Europäisches Patentamt

(19) European Patent Office

Office européen des brevets

(11) Publication number: **0 050 693**
**B1**

(12) **EUROPEAN PATENT SPECIFICATION**

(45) Date of publication of patent specification: **13.02.85**

(51) Int. Cl.⁴: **H 05 K 13/00**

(21) Application number: **80303821.5**

(22) Date of filing: **28.10.80**

(54) **Backup material for use in drilling printed circuit boards.**

(43) Date of publication of application:
**05.05.82 Bulletin 82/18**

(45) Publication of the grant of the patent:
**13.02.85 Bulletin 85/07**

(84) Designated Contracting States:
**AT BE CH DE FR GB IT LI LU NL SE**

(56) References cited:
**US-A-1 625 061**
**US-A-2 258 858**
**US-A-2 963 128**
**US-A-3 696 452**
**US-A-3 719 113**
**US-A-3 781 124**
**US-A-4 019 826**

(73) Proprietor: **LCOA LAMINATING COMPANY OF AMERICA**
**7311 Doig Drive**
**Garden Grove California 92641 (US)**

(72) Inventor: **Block, James P.**
**5868 Deborah Street**
**Long Beach California 90815 (US)**

(74) Representative: **Carpmael, John William Maurice et al**
**CARPMAELS & RANSFORD 43 Bloomsbury Square**
**London, WC1A 2RA (GB)**

Courier Press, Leamington Spa, England.

## Description

This invention relates to the drilling of printed circuit boards, and more particularly to a backup material for use in this type of operation.

In the drilling of printed circuit boards to provide apertures necessary for passing component leads therethrough and for attaching the boards in place, a problem has been encountered in that a burr is produced on the periphery of the aperture where the drill exits from the copper-clad surface. Such a burr is unacceptable in view of the fact that it forms a dam-like condition during through hole plating which can entrap contaminants or air, this often later resulting in cracking of the through hole plating and a resultant electrical failure. Such burrs thus must be removed, either by a separate sanding operation or prevented by use of a suitable backup board, the latter approach being much more desirable in view of the fact that it is less costly and does not increase the time needed for sanding.

A particularly desirable backup board for use in circuit board drilling is described in U.S. Patent No. 3,700,341, issued October 24, 1972, and assigned to L.C.O.A. Laminating Corporation of America, the assignee of the present application. This prior art backup board employs a core of hard pressed wood which is covered with outer layers of metallic foil (preferably aluminium). Another form of backup board is described in U.S. Patent 3,700,341 which has a core of pressed wood fibres with paper layers forming outer surfaces of the core and with aluminium foil outer layers bonded to the paper layers. While the backup boards of the prior art are quite effective in eliminating burrs and provides cooling of the drill, the backup board of the present invention provides a number of improvements thereover. Thus in accordance with the present invention there is a method for drilling a printed circuit board wherein backup material formed by a core (14) sandwiched between a pair of metallic sheets (11, 12) is placed beneath the circuit board, characterised in that the core (14) of the backup material is in the form of elongated channels running between opposite edges of said sheets (11, 12) and the travel of the drill is ended in the area of the channels to facilitate cooling of the drill. Firstly, the backup board of the present invention, by employing a core having therein between an upper and a lower foil sheet, further facilitates the cooling of the drill and printed circuit board workpiece by virtue of the air flow provided through the core during the drilling. Further, these open spaces in the core can be employed to facilitate the removal of cuttings from the workpiece. Further, the cooling of the drill is facilitated after drilling through the workpiece in view of the fact that the drill tip enters the open core after it penetrates the upper sheet and does not penetrate the lower sheet. It is to be noted that a vacuum system is generally employed by the drilling machine for removing cuttings from the workpiece area. The core of the present invention facilitates the optimum use of such vacuum systems both for the removal of the cuttings and for additional cooling of the printed circuit board workpiece and the drill.

It is therefore the object of this invention to provide an improved backup material and method for use in drilling printed circuit boards.

It is another object of this invention to provide an improved backup board for use in drilling printed circuit boards wherein improved means are afforded for facilitating the removal of cuttings and the cooling of the workpiece and drill.

Other objects of the invention will become apparent as the description proceeds in connection with the accompanying drawings of which:

FIG. 1 is a perspective view illustrating the backup material of the invention;

FIG. 2 is a cross-sectional view taken along the plane indicated by 2—2 in FIG. 1;

FIG. 3 is a cross-sectional view taken along the plane indicated by 3—3 in FIG. 2;

FIG. 4 is an elevational view illustrating the use of the backup material in drilling a workpiece; and

FIG. 5 is a schematic drawing illustrating the fabrication of the backup material of the present invention.

Described in brief, the backup board comprises a pair of opposing metallic foil sheets which may be of copper, magnesium or steel but are preferably of aluminium, between which is sandwiched a core member having opposing node portions, one of which faces against one of such sheets and the other of which faces against the other of the sheets. The node portions are preferably elongated running in substantially parallel lines between opposite edges of the sheets and may be approximately in the form of a sine wave. The circuit board to be drilled is placed over the backup material with the bottom surface thereof abutting against the top sheet of the backup material. After the drill has penetrated through the workpiece, it penetrates the top sheet of the backup material and enters the core space and goes no further than this space. An air flow may be provided in the core to facilitate the removal of cuttings therefrom and to aid in the cooling of the drill and the workpiece.

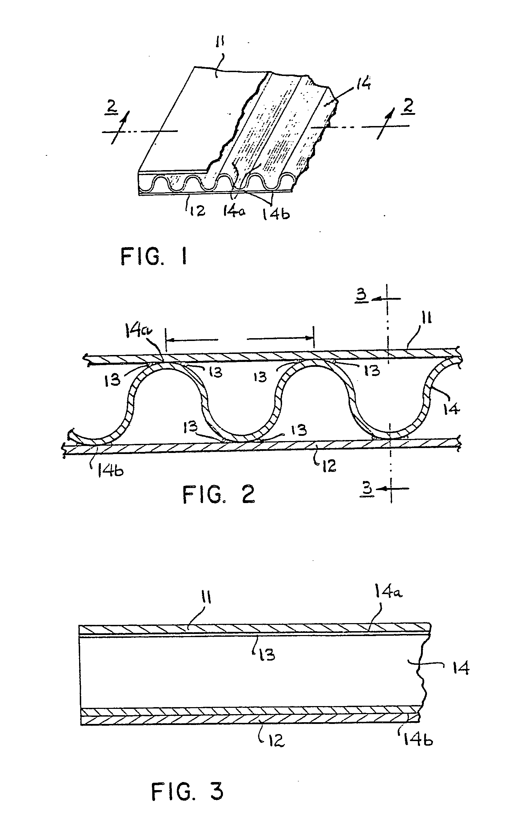

Referring now to FIGS. 1—3, a preferred embodiment of the backup material of the present invention is illustrated. The material includes an upper metallic sheet 11 and a lower metallic sheet 12, between which a sinusoidally undulating core member 14 is sandwiched. The core member 14 has opposing node portions 14a and 14b which face against the inside surfaces of sheets 11 and 12 respectively. Nodal portions 14a and 14b are bonded to sheets 11 and 12 by means of a suitable bonding material 13 and run between opposite edges of the sheets, the apices of these nodal portions abutting against the sheets and running in substantially parallel lines. It has been found that aluminium foil is particularly suitable for sheets 11 and 12 and core 14.

Excellent results have been achieved with type 3003-H19 aluminium foil having a thickness of 0.013 cm (0.005 inches) for each of these components. This type of aluminium has the following constituents added to pure aluminium: silicon—6%; iron—7%; copper—0.05—0.20%; manganese—1.0—1.5%; and zinc—0.10%. Utilizing aluminium of this type with the indicated .013 cm (.005 inch) thickness, the spacing between inner walls of the two foils should typically be approximately 0.13 cm (.053 inches) making for an overall thickness of the backup material of 0.16 cm (.063 inches). For a backup material having an overall thickness of 0.24 cm (.093 inches), the top and bottom sheets and the core typically have thickness of 0.018 cm (.007 inches) and for a backup material having an overall thickness of 0.32 cm (.125 inches), the top and bottom sheets and the core material typically have thicknesses of 0.023 cm (.009 inches).

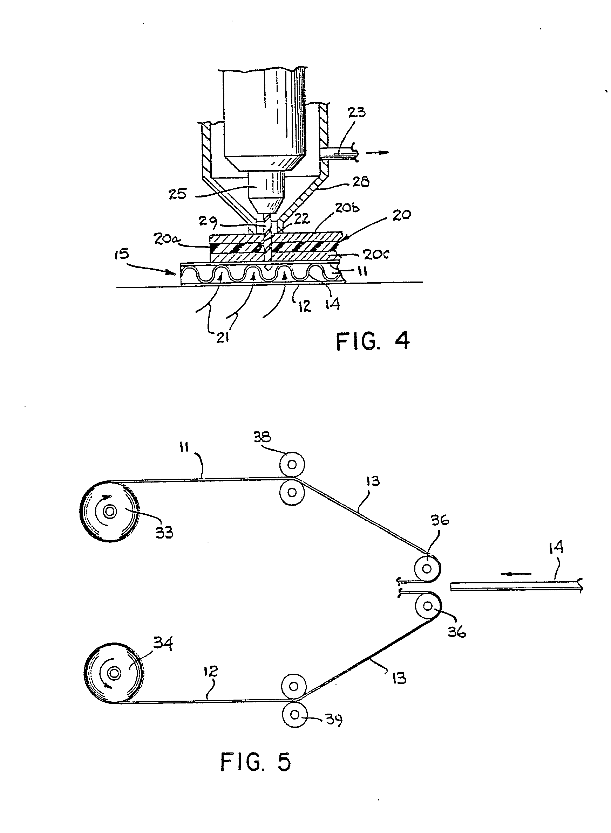

Referring now to FIG. 4, the operation of the invention is schematically illustrated. Workpiece 20, which is typically a printed circuit board with an epoxy glass substrate 20a clad with copper layers 20b and 20c on both sides thereof, is placed on a piece of the backup material 15. A supply of air, indicated by arrows 21, is provided to the area of convoluted core material 14. This supply of air flows through the drill hole 22 and out through air outlet 23. The supply of air may be provided by a blower or a suitable vacuum system, the latter being present in a typical drilling machine. The drill 25 is set so that the furthest penetration of drill bit 29 will not take it beyond the area of the core material 14, i.e., it will not penetrate the lower sheet 12 of the backup material. This enables a second use of the backup material after it has been used on one side by placing the reverse unused side up towards the drill. During the drilling operation, air will flow along the flutes of the drill bit (once penetration of the workpiece 20 has occurred) and the tip of the drill will be cooled. Throughout the drilling operation, air can be circulated through the core material which further facilitates the cooling of the drill bit and workpiece. Immediately after the drill bit has been withdrawn, the air will flow through the drill hole 22 and clear away any cuttings that may be left in this immediate area.

The device as shown in FIG. 4 includes a pressure foot 28 which moves downward immediately prior to drilling and makes contact with board 20. This action ensures that the board is absolutely flat and secure when the drill makes its initial contact. When the drill has reached the desired predetermined maximum depth, which as already indicated is not beyond the core area, the drill's downward motion is automatically stopped and an upward movement is commenced. The "stop" position between downward and upward motion, known as the "dwell", is when in prior art drillings the drill usually reaches its highest temperature. When the drill has been fully extracted, a vacuum is provided at air outlet 23 which is used to remove debris from above the workpiece. The air supply 21 which is provided into the core of the backup material aids both in the cooling process and in the removal of debris, being particularly effective in this last regard for debris below and within the hole. Thus, the use of the backup material in accordance with the present invention greatly facilitates both the cooling of the workpiece and the drill and the removal of cuttings and other debris.

Referring now to FIG. 5, the method of fabricating the backup material used in the present invention is illustrated. First and second rolls of aluminium foil 33 and 34 are rotatably supported and are unwound by means of pinch rollers 36 to which they are fed in a wound-back relationship. Prior to reaching pinch rollers 36, the surfaces of sheets 11 and 12 pass through rollers 38 and 39 which coat the outer surfaces of the sheets with a layer of bonding material 13. It has been found that an epoxy resin adhesive bonding agent having a 50—50 composition of epoxy and hardener provides a suitable bonding agent. Simultaneously passed through the pinch rollers sandwiched between sheets 11 and 12 is the sinusoidally undulated core material 14. The sinusoidal undulations of core material 14 can be formed in flat sheets of the foil by means of a suitable pair of forming rollers. Typically, the undulations are formed so that the nodes thereof run substantially parallel to each other along the longitudinal dimension of the core. Typically, a 0.05 cm (.002 inch) layer of bonding material 13 is provided to each of the metallic foil sheets. After the sandwich core material is passed through pinch rollers 36, final bonding is effected at a pressure of $172 \times 10^3$ $Nm^{-2}$ to $2240 \times 10^3$ $Nm^{-2}$ (25—325 psi) $343 \times 10^3$ $Nm^{-2}$ (150 psi) being found optimum in the preferred embodiment) at a temperature of 51°C to 287°C (125—550°F) 116°C (240°F) being found optimum in the preferred embodiment), this end result being achieved by placing the material between a pair of tooling or "caul" plates which are then placed in a heated laminating press where the above indicated heat and pressure are applied.

**Claims**

1. A method for drilling a printed circuit board wherein a backup material formed by a core (14) sandwiched between a pair of metallic sheets (11, 12) is placed beneath the circuit board characterised in that the core (14) of the backup material is in the form of elongated channels running between opposite edges of said sheets (11, 12) and the travel of the drill is ended in the area of the channels to facilitate cooling of the drill.

2. The method of Claim 1 characterised in that the channels run substantially parallel to each other between said opposite edges of the sheets.

3. The method of Claim 2 characterised in that the channels are substantially sinusoidal.

4. The method of Claim 3 characterised in that the sheets (11, 12) and the material of said core (14) are of aluminium and·have a thickness of approximately 0.013 cm, the overall thickness of the backup board being approximately 0.16 cm.

5. The method of Claim 1 and characterised by including the step of providing an airflow through the core (14) to cool the printed circuit board and the drill and to remove cuttings.

6. A backup material for use in drilling printed circuit boards, said material being formed by a core (14) sandwiched between a pair of sheets (11, 12) of aluminium foil in opposing relationship to each other, characterised in that the core (14) is formed from an aluminium foil having an undulating shape with opposing node portions (14a, 14b) facing against the opposing pair of sheets (11, 12) the node portions running in substantially parallel lines between the edges of said pair of sheets.

7. The material of Claim 6 wherein the core member is sinusoidal.

8. The material of Claim 7 wherein the thickness of all of the said sheets is approximately .01778 cm and the overall thickness of the backup material is approximately .2362 cm.

## Patentansprüche

1. Verfahren zum Bohren einer Printplatte, bei welchem ein Unterlagsmaterial, das aus einem sandwichartig zwischen zwei Metallblättern (11, 12) angeordneten Kern (14) besteht, unterhalb der Printplatte angeordnet wird, dadurch gekennzeichnet, daß der Kern (14) des Unterlagsmaterials in Form länglicher Kanäle vorliegt, die zwischen gegenüberliegenden Rändern der genannten Blätter (11, 12) verlaufen und daß der Weg des Bohrers im Bereich der Kanäle endet, um das Kühlen des Bohrers zu erleichtern.

2. Verfahren nach Anspruch 1, dadurch gekennzeichnet, daß die Kanäle im wesentlichen parallel zueinander zwischen den genannten gegenüberliegenden Rändern der Blätter verlaufen.

3. Verfahren nach Anspruch 2, dadurch gekennzeichnet, daß die Kanäle im wesentlichen sinusförmig sind.

4. Verfahren nach Anspruch 3, dadurch gekennzeichnet, daß die Blätter (11, 12) und das Material des genannten Kerns (14) aus Aluminium bestehen und eine Dicke von etwa 0,013 cm aufweisen, wobei die Gesamtdicke der Unterlagsplatte etwa 0,16 cm beträgt.

5. Verfahren nach Anspruch 1 und gekennzeichnet durch das Vorliegen einer Stufe zur Schaffung eines Luftstroms durch den Kern (14) zum Kühlen der Printplatte und des Bohrers sowie zur Entfernung des Bohrmehls.

6. Unterlagsmaterial zur Verwendung beim Bohren von Printplatten, welches aus einem sandwichartig zwischen zwei einander gegenüberliegenden Blättern (11, 12) aus Aluminiumfolie angeordneten Kern (14) besteht, dadurch gekennzeichnet, daß der Kern (14) aus einer Aluminiumfolie mit gewellter Form und einander gegenüberliegenden Knotenteilen (14a, 14b) besteht, die an den einander gegenüberliegenden Blättern (11, 12) anliegen, wobei die Knotenteile im wesentlichen entlang paralleler Linien zwischen den Rändern der beiden Blätter verlaufen.

7. Material nach Anspruch 6, bei welchem der Kernteil sinusförmig ist.

8. Material nach Anspruch 7, bei welchem die Dicke all der genannten Blätter etwa 0,01778 cm und die Gesamtdicke des Unterlagsmaterials etwa 0,2362 cm beträgt.

## Revendications

1. Procédé pour effectuer le perçage d'une plaque à circuits imprimés, en utilisant un matériau de contreplaque (ou d'appui) comportant une âme (14) disposée en sandwich entre deux feuilles métalliques (11, 12), que l'on place contre la plaque à circuits imprimés, caractérisé en ce que l'âme (14) du matériau d'appui est formée de canaux allongés, qui s'étendent entre des bords opposés des feuilles précitées (11, 12); et en ce qu'on arrête la course d'enfoncement du foret dans la zone des canaux, pour faciliter le refroidissement du foret.

2. Procédé selon la revendication 1, caractérisé en ce que les canaux de l'âme s'étendent à peu près parallèlement l'un à l'autre entre les bords opposés des feuilles.

3. Procédé selon la revendication 2, caractérisé en ce que les canaux ont un profil sensiblement sinusoïdal.

4. Procédé selon la revendication 3, caractérisé en ce que les feuilles (11, 12) ainsi que la matériau de l'âme (14) sont en alliage d'aluminium, avec une épaisseur d'environ 0,13 mm, l'épaisseur totale de la plaque d'appui étant d'environ 1,6 mm.

5. Procédé selon la revendication 1, caractérisé en ce qu'on fait passer un courant d'air dans l'âme (14), pour refroidir la plaque à circuit imprimés ainsi que le foret, et pour enlever les copeaux.

6. Matériau de contre-plaque (ou d'appui) utilisable pour perçage des plaques à circuits imprimés; ce matériau comportant une âme (14) disposée en sandwich entre deux feuilles (11, 12) d'aluminium, opposées de part et d'autre de l'âme; caractérisé en ce que l'âme (14) est constituée par une feuille d'aluminium de forme ondulée, comportant des ondulations opposées (14a, 14b), situées chacune en regard de l'une des deux feuilles opposées (11, 12) et appliquées contre ces feuilles; ces ondulations étant à peu près parallèles entre elles, et s'étendant entre les bords des deux feuilles précitées.

7. Matériau selon la revendication 6, caractérisé en ce que l'âme présente un profil sinusoïdal.

8. Matériau selon la revendication 7, caractérisé en ce que toutes les feuilles précitées ont chacune une épaisseur d'environ 0,1178 mm, l'épaisseur totale du matériau d'appui étant d'environ 2,362 mm.

FIG. 1

FIG. 2

FIG. 3

FIG. 4

FIG. 5